(19) Europäisches Patentamt / European Patent Office / Office européen des brevets

(11) **EP 3 223 277 A1**

(12) **EUROPEAN PATENT APPLICATION**

(43) Date of publication:
27.09.2017 Bulletin 2017/39

(51) Int Cl.:
*G10L 21/00* $^{(2013.01)}$     *H03H 17/06* $^{(2006.01)}$

(21) Application number: 17161806.9

(22) Date of filing: 20.03.2017

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: 21.03.2016  US 201662311268 P
21.03.2016  EP 16161402

(71) Applicant: **Dolby International AB**
**1101 CN  Amsterdam Zuidoost (NL)**

(72) Inventors:
• **MUNDT, Harald**
**90429 Nuremberg (DE)**
• **PEICHL, Klaus**
**90429 Nuremberg (DE)**
• **SCHILDBACH, Wolfgang**
**90429 Nuremberg (DE)**

(74) Representative: **Dolby International AB**
**Patent Group Europe**
**Apollo Building, 3E**
**Herikerbergweg 1-35**
**1101 CN Amsterdam Zuidoost (NL)**

(54) **EFFICIENT SAMPLE RATE CONVERSION**

(57)    A method (500) for resampling an audio signal (110) is described. The method (500) comprising providing (501) a set of input subband signals (210) which is representative of a time domain audio signal. Furthermore, the method (500) comprises applying (502) a first ripple pre-emphasis gain (323) to a first input subband signal (210) of the set of input subband signals (210) to determine a corresponding first output subband signal (213) of a set of output subband signals (213). In addition, the method (500) comprises determining (503) a time domain input audio signal (110) from the set of output subband signals (213). The method (500) further comprises performing (504) time domain resampling of the input audio signal (110) to provide an output audio signal (113) using an anti-aliasing filter (102), wherein the first ripple pre-emphasis gain (323) is dependent on a frequency response (311) of the anti-aliasing filter (102), such that an amplitude ripple of the frequency response (311) of the anti-aliasing filter (102) is at least partially compensated by the first ripple pre-emphasis gain (323).

FIG. 5

## Description

### TECHNICAL FIELD

The present document relates to efficient resampling of audio signals, notably in the context of an audio decoder.

### BACKGROUND

Different audio formats may require different sampling rates (e.g. 32 kHz, 44.1 kHz or 48 kHz). In addition, in the context of video frame rate synchronous audio coding (e.g. AC4 coding), the sample rate of the encoded audio is typically modified dependent on the video frame rate and may need to be re-sampled at the required audio sampling rate within the decoding process. In order to transfer an audio signal at a first sampling rate (e.g. at 32 kHz) to an audio signal at a second sampling rate (e.g. at 48 kHz) rational resamplers may be used. The resampling of audio by rational factors typically introduces imaging/aliasing artifacts into the resampled audio signal. An anti-imaging/anti-aliasing filter may be used to suppress the unwanted images and/or aliases of the audio signal. Anti-imaging/anti-aliasing filters typically have a relative high number of filter taps, wherein the number of filter taps typically increases with the quality of the filters. As a result of this, time domain resampling typically exhibits significant computational complexity. EP 2 649 614 A1 describes a method for designing such an anti-imaging/anti-aliasing filter.

The present document is directed at the technical problem of reducing the computational complexity for the resampling of audio signals, notably in the context of an audio processing system which makes use of subband processing, such as an audio decoder.

### SUMMARY

According to an aspect, a method for resampling an audio signal is described. The method comprises providing a set of input subband signals. The set of input subband signals may be representative of a time domain audio signal, e.g. at an input sampling rate $fs_{in}$. The audio signal is to be resampled to provide an audio signal at an output sampling rate $fs_{out}$, which is different from the input sampling rate $fs_{in}$. The set of input subband signals may be derived from encoded audio data (notably AC4 audio data) taken from a bitstream. The audio data from the bitstream may be representative of a time domain audio signal at the input sampling rate $fs_{in}$, notably of a lowband audio signal. The lowband audio signal may exhibit spectral energy only within a lower portion of the spectral band ranging from 0 to $fs_{in}/2$. By way of example, the lowband audio signal may exhibit spectral energy only within the spectral band ranging from 0 to $fs_{in}/4$.

The step of providing the set of input subband signals may comprise, applying an analysis filterbank comprising a plurality of analysis filters to the time domain audio signal, notably to the lowband audio signal. The analysis filters may comprise quadrature mirror filters (QMF), e.g. Q = 32, 64 or more analysis filters. The analysis filterbank may cover a spectral band from 0Hz to the Nyquist frequency (i.e. $fs_{in}/2$) of the audio signal, which is to be resampled. As such, the analysis filterbank may subdivide the spectral band from 0Hz to the Nyquist frequency into Q different subbands each covering a different frequeny range between 0Hz and $fs_{in}/2$.

Furthermore, the method may comprise determining a set of lowband subband signals by applying the analysis filterbank to the lowband audio signal. The set of lowband subband signals may only comprise energy within a portion of the Q subbands (e.g. within the subbands having the subband indexes 1 to Q/2). The method may further comprise performing spectral band expansion using the set of lowband subband signals and one or more spectral band expansion parameters (which may be derived from the bitstream) to provide the set of input subband signals. The set of input subband signals may comprise energy within an increased number of subbands (compared to the set of lowband subband signals). As such, the set of input subband signals may be determined in the context of an audio decoder which makes use of an analysis filterbank to perform spectral band expansion.

The method may further comprise applying a first ripple pre-emphasis gain to a first input subband signal of the set of input subband signals to determine a corresponding first output subband signal of a set of output subband signals. In particular, a plurality of different ripple pre-emphasis gains may be applied to a corresponding plurality of different input subband signals to determine a corresponding plurality of output subband signals. By way of example, different ripple pre-emphasis gains may be applied to some or all of the Q different input subband signals. Applying the ripple pre-emphasis gain typically comprises multiplying the (notably real-valued) ripple pre-emphasis gain to the (possibly complex) samples of an input subband signal, to determine a (possibly complex) sample of the output subband signal. As such, the ripple pre-emphasis gain typically only modifies the amplitude of an input subband signal.

The method further comprises determining a time domain input audio signal from the set of output subband signals. The set of output subband signals typically comprises Q output subband signals for the Q different subbands. Determining the time domain input audio signal typically comprises applying a synthesis filterbank comprising a plurality of synthesis filters (notably Q synthesis filters) to a set of subband signals derived from the set of output subband signals. The plurality of synthesis filters may be applied directly to the set of output subband signals. Alternatively, the set of output subband signals may be applied to further processing (such as decoupling or upmixing) prior to being converted into one or more time domain audio signals. The synthesis filters may comprise quadrature mirror filters and the number Q of analysis filters may be 32, 64 or more.

In addition, the method comprises performing time domain resampling of the input audio signal to provide an output audio signal. The time domain resampling involves using an anti-aliasing (or anti-imaging) filter, which typically comprises a set of coefficients.

The first ripple pre-emphasis gain may be dependent on a frequency response of the anti-aliasing filter. In particular, the method may comprise determining the first ripple pre-emphasis gain based on the frequency response of the anti-aliasing filter. By way of example, the first ripple pre-emphasis gain may be dependent on an amplitude ripple of the frequency response of the anti-aliasing filter, notably on an amplitude ripple within the pass band of the anti-aliasing filter and/or within the frequency range from 0Hz up to $fs_{in}/2$. The first ripple pre-emphasis gain may be such that that an amplitude ripple of the frequency response of the anti-aliasing filter is at least partially compensated by the first ripple pre-emphasis gain.

By making use of a ripple pre-emphasis gain which is dependent on the frequency response of the anti-aliasing filter that is used for time domain resampling, artifacts which are caused by an amplitude ripple of the anti-aliasing filter may be compensated using the ripple pre-emphasis gain. This allows the use of relatively short anti-aliasing filters (which typically exhibit a substantial amplitude ripple) to reduce the computational complexity of time domain resampling, without causing amplitude-artifacts within the resampled output audio signal. In particular, the relatively short anti-aliasing filters may be designed such that stop band attenuation remains unchanged (compared to anti-aliasing filters having an increased number of filter taps), while amplitude ripple increases.

Regarding the nomenclature used within the present document, it should be noted that the set of input subband signals is "input" to ripple pre-emphasis gain processing, wherein the set of output subband signals is "output" from pre-emphasis gain processing. In an analogous manner, the (time domain) input audio signal (which is derived from the set of output subband signals) is "input" to time domain resampling, wherein the (time domain) output audio signal is "output" from time domain resampling.

As indicated above, the set of input subband signals typically comprises Q input subband signals for Q different subbands. The first input subband signal may correspond to a first subband from the Q different subbands, i.e. to one of the Q subbands within the frequency range from 0Hz to $fs_{in}/2$. The first ripple pre-emphasis gain may be dependent on the frequency response of the anti-aliasing filter within the first subband. In particular, the first ripple pre-emphasis gain may be such that the amount of amplitude ripple within the first subband may be compensated (at least partially) by application of the first ripple pre-emphasis gain. By way of example, the first ripple pre-emphasis gain may be dependent on an average amplitude or a median amplitude of the frequency response of the anti-aliasing filter within the first subband.

Typically, the amplitude of the frequency response of the anti-aliasing filter should be at a constant reference value (e.g. of 1 (on a linear scale) or 0dB (on a logarithmic scale) within the entire pass band of the anti-aliasing filter (wherein the pass band typically ranges from 0Hz to the Nyquist frequency $fs_{in}/2$ of the input audio signal or to the Nyquist frequency $fs_{out}/2$ of the output audio signal, whichever is smaller). The first ripple pre-emphasis gain may be such that it at least partially compensates a deviation of the amplitude of the frequency response of the anti-aliasing filter within the first subband from the reference value. The ripple pre-emphasis gains for others of the plurality of subbands may be determined in the same manner. As a result of this, the amplitude ripple of the anti-aliasing filter may be compensated (at least partially) by pre-emphasizing the different spectral components of the input audio signal (i.e. by pre-emphasizing the set of input subband signals) prior to submitting the input audio signal to the time domain resampler.

As such, the method may comprise applying different ripple pre-emphasis gains to different input subband signals of the set of input subband signals. The different ripple pre-emphasis gains may be such that the ripple pre-emphasis gains at least partially compensate the amplitude ripple of the frequency response of the anti-aliasing filter.

In other words, the method may comprise applying different ripple pre-emphasis gains to the different input subband signals, wherein the ripple pre-emphasis gains for the different subbands form a frequency-dependent gain curve (as a function of frequency or as a function of subband indexes). In a similar manner, the frequency response of the anti-aliasing filter exhibits a frequency-dependent amplitude curve (as a function of frequency or as a function of subband indexes).

The frequency-dependent gain curve (for the up to Q subbands) may be determined based on the frequency-dependent amplitude curve. In particular, the different ripple pre-emphasis gains may be such that the frequency-dependent gain curve approximates an inverse or a mirrored version of the frequency-dependent amplitude curve (wherein the inverse or a mirrored version of the frequency-dependent amplitude curve may be determined by mirroring the frequency-dependent amplitude curve at a straight line corresponding to the reference value).

Alternatively or in addition, the different ripple pre-emphasis gains may be such that a deviation of the frequency-dependent gain curve from the inverse of the frequency-dependent amplitude curve is equal to or smaller than a deviation threshold. The deviation threshold may be dependent on the amount of artifacts which are considered to be acceptable at the output of the time domain resampler. Alternatively or in addition, the different ripple pre-emphasis gains may be such that a product of the frequency-dependent gain curve and the frequency-dependent amplitude curve provides a frequency-dependent product curve having a variance which is lower than a variance of the frequency-dependent amplitude curve, thereby reducing the amount of artifacts at the output of the time domain resampler.

The time domain input audio signal may be determined using a synthesis filterbank comprising Q synthesis filters. The first ripple pre-emphasis gain may be dependent on a power response of at least one of the Q synthesis filters.

In particular, the one or more pre-emphasis gains may be determined in a least squares error sense. G may be a row vector comprising L squared ripple pre-emphasis gains for L input subband signals. P may be a matrix with size LxK, which is indicative of the power response of L analysis-synthesis filters at K pass band frequency points, i.e. of the power response of L combinations of analysis and synthesis filters. A typical value for K is K=512. T may be a row vector which is indicative of a power response of the anti-aliasing filter at the K pass band frequency points. The power response of a filter may be determined by squaring the amplitude values of the frequency response of the filter. G may be determined such that GxP=1/T is fulfilled or approximated in the least squares error sense. As a result of this, the squared values of the L ripple pre-emphasis gains may be determined.

The above mentioned schemes enable the determination of ripple pre-emphasis gains which increase the perceptual quality of the resampled output audio signal.

As already outlined above, the method for resampling an audio signal may be used in conjunction with other audio processing within the subband domain. In particular, the method for resampling an audio signal may be used in conjunction with an audio encoder or an audio decoder. By way of example, an audio decoder may make use of an analysis / synthesis filterbank to perform spectral band expansion and/or upmixing of an audio signal. As a result of this, the set of input subband signals are determined by default, thereby reducing the computational complexity of the described method for resampling.

In particular, the method may comprise upmixing the set of output subband signals to a first and a second set of output subband signals using one or more upmixing parameters. Such upmixing may e.g. be performed in the context of audio decoding and the one or more upmixing parameters may be provided as metadata within a bitstream that is indicative of an encoded audio signal. The one or more upmixing parameters may e.g. comprise parametric stereo upmixing parameters. The method may further comprise deriving the set of subband signals to which the synthesis filterbank is applied from the first set of output subband signals or from the second set of output signals.

As such, the ripple pre-emphasis gains may be applied to a downmixed set of subband signals which is subsequently upmixed to provide a plurality of sets of subband signals for a plurality of different time domain audio signals. The plurality of different audio signal may then be resampled using a time domain resampler. Hence, ripple pre-emphasis may be applied only once for providing a plurality of different resampled audio signals. By doing this, the computational complexity for resampling may be further reduced.

As already indicated above, the input audio signal typically exhibits an input sampling rate $fs_{in}$ and the output audio signal typically exhibits an output sampling rate $fs_{out}$ (which is usually different from the input sampling rate $fs_{in}$). The ratio of the output sampling rate $fs_{out}$ and the input sampling rate $fs_{in}$ may be a rational number N/M. As a result of this, time domain resampling may be performed by upsampling the input audio signal by a factor N to provide an intermediate audio signal and by subsequently downmixing the intermediate audio signal by a factor M to provide the resampled output audio signal.

N and M may be mutually prime. In an embodiment, neither N nor M are equal to 1, meaning that the resampler is neither a pure upsampler by an integer factor N nor a pure downsampler by an integer factor M. In other words, the resampler may comprise an upsampling component by a factor N>1 and a downsampling component by a factor M>1. In yet other words, the fraction N/M may not be an integer value and the fraction M/N may not be an integer value. By way of example, for $fs_{in}$=40kHz, $fs_{out}$=48kHz, N=6, M=5; or for $fs_{in}$=32kHz, $fs_{out}$=48kHz, N=3, M=2; or for $fs_{in}$=44.1kHz, $fs_{out}$=48kHz, N=160, M=147; or for $fs_{in}$=32kHz, $fs_{out}$=44.1kHz, N=441, M=320; or vice versa, i.e. for $fs_{in}$=48kHz, $fs_{out}$=40kHz, N=5, M=6; or for $fs_{in}$=48kHz, $fs_{out}$=32kHz, N=2, M=3; or for $fs_{in}$=48kHz, $fs_{out}$=44.1kHz, N=147, M=160; or for $fs_{in}$=44.1kHz, $fs_{out}$=32kHz, N=320, M=441. In further examples (notably in the context of AC4), the resample ratios may be as follows: $fs_{in}$=46,03397kHz, $fs_{out}$=48kHz, N=25025, M=24000; $fs_{in}$=46,080kHz, $fs_{out}$=48kHz, N=25, M=24; or $fs_{in}$=51,2kHz, $fs_{out}$=48kHz, N=15, M=16.

In order to avoid aliasing and imaging, resampling typically involves applying an anti-aliasing filter which comprises a set of coefficients. In particular, performing time domain resampling may comprise multiplying a coefficient from the set of coefficients with a sample of the input audio signal to determine a sample of the output audio signal. As such, time domain resampling involves a substantial amount of multiply-operations, wherein the amount of multiply-operations increases with the number of coefficients of the anti-aliasing filter. Hence, reducing the number of coefficients reduces the computational complexity of time domain resampling.

The method may comprise determining a weighted deviation of the frequency response of the anti-aliasing filter from a target frequency response, using a pass band weight for a pass band of the frequency responses and a stop band weight for a stop band of the frequency responses. Typically, the target frequency response corresponds to the frequency response of a low pass filter having a cut-off frequency at the Nyquist frequency ($fs_{in}/2$) of the input audio signal or to the Nyquist frequency ($fs_{out}/2$) of the output audio signal (whichever is smaller). The pass band of the target frequency response typically ranges from 0Hz to the cut-off frequency and the stop band of the target frequency response typically ranges from the cut-off frequency to higher frequencies. The stop band weight and the pass band weight may be used to put emphasis on the precision of the frequency response of the anti-aliasing filter with respect to the target frequency response within the pass band (by increasing the pass band weight relative to the stop band weight) or within the stop band (by increasing the stop band weight relative to the pass band weight).

The method may comprise the step of determining coefficients of the anti-aliasing filter such that the frequency response of the anti-aliasing filter is fitted to the target frequency response and/or such that the weighted deviation is reduced. The weighted deviation may be defined using a maximum absolute difference criteria or a least mean square criteria. In particular, the coefficients of the anti-aliasing filter may be determined using a Remez exchange algorithm or Parks-McClellan algorithm.

Furthermore, the method may comprise determining a stop band deviation of the frequency response of the anti-aliasing filter from the target frequency response within the stop band. The pass band weight and the stop band weight which are used for determining the (coefficients of the) anti-aliasing filter may be determined such that the stop band deviation is equal to or smaller than a pre-determined deviation threshold. In particular, the pass band weight and the stop band weight may be adjusted in an iterative process, wherein during each iteration an anti-aliasing filter is determined using fixed values of the pass band weight and the stop band weight. Furthermore, the stop band deviation of the frequency response of the anti-aliasing filter is determined and it is verified whether the stop band deviation is equal to or smaller than the pre-determined deviation threshold. If this is the case, the iterative process stops. On the other hand, if the stop band deviation is too high, the stop band weight is increased relative to the pass band weight and a new anti-aliasing filter is determined, and it is verified whether the stop band deviation for the new anti-aliasing filter is sufficiently low.

By adjusting the stop band weight relative to the pass band weight, an anti-aliasing filter may be determined, which exhibits good stop band attenuation (e.g. in the range of the stop band attenuation of an anti-aliasing filter having an increased number of filter coefficients) and which exhibits relatively high amplitude ripple in the pass band. By way of example, the deviation threshold may be set in accordance to the stop band deviation of an anti-aliasing filter having an increased number of filter taps. Due to the fact that the amplitude ripple may be compensated using pre-emphasis gains in the subband domain, good stop band attenuation and low amplitude ripple may be achieved, thereby providing a resampled output audio signal with reduced artifacts.

The method may comprise selecting a first subset of coefficients from the set of coefficients. This first subset may comprise a first coefficient from the set of coefficients and additional coefficients from the set of coefficients following the first coefficient by multiples of N. In other words, every $N^{th}$ coefficient (starting from the first coefficient) from the set of coefficients may be selected for the first subset of coefficients.

The method may further comprise the step of determining a first sample of the output audio signal based on the first subset of coefficients and a first plurality of samples of the input audio signal. In other words, a first sample of the output audio signal may be determined by filtering a first plurality of samples of the input audio signal using a filter based on the first subset of coefficients.

In order to determine a second sample of the output audio signal, the method may comprise the step of selecting a second coefficient of the set based on the first coefficient and M. The method may proceed in selecting a second subset of coefficients from the set of coefficients, wherein the second subset comprises the second coefficient and coefficients from the set of coefficients following the second coefficient by multiples of N. In other words, the method may proceed in selecting a second subset comprising a shifted subset of filter coefficients. Finally, the method may determine the second sample of the output audio signal directly following the first sample, based on the second subset of coefficients and a second plurality of samples of the input audio signal.

As such, the samples of the output audio signal may be determined using a polyphase finite impulse response implementation of the anti-aliasing filter, thereby further reducing the computational complexity for resampling an audio signal.

As indicated above, the frequency response may exhibit an amplitude ripple in a pass band range from 0Hz to the Nyquist frequency ($fs_{in}/2$) of the input audio signal or to the Nyquist frequency ($fs_{out}/2$) of the output audio signal (whichever is smaller). The amplitude ripple may exhibit R periods (or full waves) within the pass band range. R and Q may be such that the ratio Q/R is equal to or greater than a pre-determined resolution value, with the resolution value being 10, 20, 50 or more. In other words, the analysis / synthesis filterbank and/or the anti-aliasing filter may be designed such that the ratio Q/R fulfills the above mentioned criteria. As a result of this, the application of ripple pre-emphasis gains enables a precise compensation of the amplitude ripple of the anti-aliasing filter. Typically, the quality of the compensation increases with an increasing ratio Q/R.

The method may comprise determining a bandwidth of the input audio signal. The bandwidth of the input audio signal may e.g. be determined based on the one or more spectral band expansion parameters used for spectral band expansion. In particular, it may be determined that the set of input subband signals does not comprise any (substantial) energy for at least one or more of the Q subbands. The method may further comprise determining a number of input subband signals from the set of input subband signals to which a ripple pre-emphasis gain is to be applied, based on the bandwidth of the input audio signal. In particular, no ripple pre-emphasis gain may be applied to the one or more of the Q subbands that do not comprise any substantial energy, i.e. to the one or more of the Q subbands which go beyond the bandwidth of the input audio signal. As a result of this, the computational complexity of the described resampling method may be reduced further.

The method may comprise determining a number L of subbands to which a ripple pre-emphasis gain is to be applied, based on the output sampling rate and the input sampling rate. In particular, L may be determined based on the ratio of the output sampling rate $fs_{out}$ and the input sampling rate $fs_{in}$, if the output sampling rate $fs_{out}$ is smaller than the input sampling rate $fs_{in}$. By way of example, L may be set equal to a rounded or truncated value of $fs_{out}/fs_{in} *Q$. On the other hand, L may be determined based on Q, if the output sampling rate $fs_{out}$ is equal to or greater than the input sampling rate $fs_{in}$. By way of example, L may be set equal to Q. The method may then comprise applying a ripple pre-emphasis gain to L out of the Q input subband signals. In particular, a ripple pre-emphasis gain may be applied at the most to L out of the Q input subband signals. No ripple pre-emphasis gain may be applied to the other input subband signals (for the subbands having the subband indexes L+1 to Q). As such, the method may determine whether one or more of the input subband signals may be ignored due to the subsequent resampling of the input audio signal. If this is the case, no ripple pre-emphasis may be performed for these subbands, thereby further reducing the computational complexity.

According to a further aspect, a system for determining a resampled output audio signal is described. The system comprises a transform unit configured to provide a set of input subband signals (e.g. using an analysis filterbank). Furthermore, the system comprises a pre-emphasis unit which is configured to apply a first ripple pre-emphasis gain to a first input subband signal from the set of input subband signals to determine a corresponding first output subband signal from a set of output subband signals. In addition, the system comprises an inverse transform unit which is configured to determine a time domain input audio signal based on the set of output subband signals. The transform unit and the inverse transform unit may form a (near) perfect reconstruction filterbank and/or a complex-valued filterbank. The filterbank may be configured to suppress aliasing distortions to a relatively large extent in case of subband modification. In other words, the filterbank may be designed to have a relatively low degree of sensitivity to aliasing caused by subband modification. The system further comprises a resampling unit which is configured to perform time domain resampling of the input audio signal to provide an output audio signal using an anti-aliasing filter. The first ripple pre-emphasis gain is dependent on a frequency response of the anti-aliasing filter.

According to a further aspect, an audio decoder configured to provide an output signal from a bitstream comprising audio data and metadata is described. The audio decoder comprises the system for resampling described in the present document, wherein the transform unit of the system is configured to provide the set of input subband signals based on the audio data of the bitstream. Furthermore, the audio decoder may comprise a spectral band expansion unit which is configured to provide at least some of the set of input subband signals using the metadata.

According to a further aspect, a software program is described. The software program may be adapted for execution on a processor and for performing the aspects and features outlined in the present document when carried out on a computing device.

According to another aspect, a storage medium comprising a software program is described. The software program may be adapted for execution on a processor and for performing the aspects and features outlined in the present document when carried out on a computing device.

According to a further aspect, a computer program product is described. The computer program product may comprise executable instructions for performing the aspects and features outlined in the present document when executed on a computer.

It should be noted that the methods and systems including its preferred embodiments as outlined in the present document may be used stand-alone or in combination with the other methods and systems disclosed in this document. Furthermore, all aspects of the methods and systems outlined in the present document may be arbitrarily combined. In particular, the features of the claims may be combined with one another in an arbitrary manner.

SHORT DESCRIPTION OF THE FIGURES

The methods and systems described in the present document are explained below in an exemplary manner with reference to the accompanying drawings, wherein

Fig. 1 illustrates a conceptual diagram of an example time domain resampler;
Fig. 2 shows a block diagram of an example audio decoder comprising a sample rate converter or time domain resampler;
Fig. 3a shows example magnitude frequency responses of different anti-aliasing filters of a time domain resampler;

Fig. 3b shows example magnitude frequency responses of different anti-aliasing filters within a pass band;

Fig. 4 shows the effective frequency response of an anti-aliasing filter when using subband domain ripple pre-emphasis; and

Fig. 5 shows a flow chart of an example method for resampling an audio signal.

DETAILED DESCRIPTION OF THE FIGURES

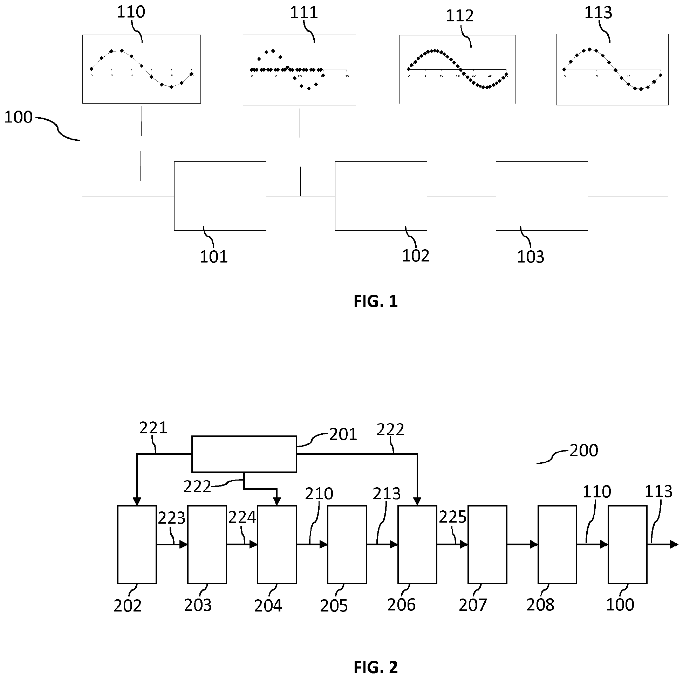

Fig. 1 illustrates conceptually a time domain resampler 100 for rational resampling factors N/M. The time domain resampler 100 comprises an up-by-N upsampler 101 which converts a sample of an input audio signal 110 into N samples of an upsampled audio signal 111. This may be achieved by inserting N-1 zeros between two samples of the input audio signal 110. Subsequently, the upsampled audio signal is filtered by an anti-aliasing/anti-imaging filter 102 with transfer function H(z). This results in a filtered audio signal 112. Finally, the filtered audio signal 112 is passed to a down-by-M decimator or downsampler 103 which only retains every M$^{th}$ sample of the filtered audio signal 112, to thereby provide the resampled (or output) audio signal 113. In case of a resampling of an input audio signal 110 at a sampling rate of 32 kHz to an output audio signal 113 at a sampling rate of 48 kHz, N is 3 and M is 2. In case of a resampling of an input audio signal 110 at a sampling rate of 44.1 kHz to an output audio signal 113 at a sampling rate of 48 kHz, N is 160 while M is 147.

It should be noted that the filter 102 runs at an intermediate frequency (IF) at N times the input sampling rate or at M times the output sampling rate (e.g. IF=M*48 kHz for the above mentioned cases). This means that the anti-aliasing filters 102 typically operate at high sampling rates, such that a reduction of the number of computational filter operations is desirable. In other words, it is desirable to reduce the number of required coefficients of the anti-aliasing filter 102, in order to reduce the overall computational complexity of the time domain resampler 100.

The filters 102 may be realized as a polyphase FIR (Finite Impulse Response) implementation. Such an implementation exploits the fact that the upsampled audio signal 111 which is filtered by filter 102 comprises N-1 zeros between the samples of the input audio signal 110. Consequently, the "zero" multiplications and additions can be omitted. Furthermore, a polyphase implementation exploits the fact that due to the subsequent down-by-M decimator 103, only every M$^{th}$ sample of the filtered audio signal 112 needs to be determined. By exploiting this information during the filter implementation, the number of multiplication and/or adding operations can be significantly reduced, thereby reducing the computational complexity of the time domain resampler 100.

Nevertheless, it is desirable to further reduce the computational complexity or to further improve the perceptual performance of the resampler 100.

As indicated above, the resampling operation creates imaging and/or aliasing artifacts in the output audio signal 113 if no anti-aliasing filter 102 is used. These imaging and/or aliasing artifacts are created as a result of the upsampling 101 and downsampling 103 operations. An anti-aliasing filter 102 may be designed by defining a target frequency response of the anti-aliasing filter 102 such that imaging and/or aliasing artifacts in the output audio signal 113 are avoided. The filter coefficients of a filter 102 meeting or approximating such target frequency response may be determined using filter design methods such as the Parks-McClellan algorithm. This algorithm determines the set of filter coefficients that minimize the maximum deviation from the target frequency response.

The Parks-McClellan algorithm is directed at minimizing the maximum of an approximation error $E(f)$ given by

$$E(f) = W(f)\big|D(f) - H(f)\big|,$$

wherein $D(f)$ is the desired form of the low pass filter 102, i.e. the target frequency response, and is typically given by

$$D(f) = \begin{cases} 1, f \in [0, f_p] \\ 0, f \in [f_s, Mfs_{out}/2] \end{cases},$$

with $f_p$ being the pass band edge and $f_s$ being the stop band edge. $W(f)$ is a frequency dependent weighting function of the approximation error. In particular $W(f)$ may comprise one or more pass band weights for the pass band and one or more stop band weights for the stop band of the filter 102. $H(f)$ is given by

$$H(f) = \sum_{k=0}^{n} d_k \cos(2k\pi f),$$

and relates to the frequency response of the filter 102 by $exp(-j2\pi nf)H(f)$. The filter coefficients $h_k$ of filter 102 are given by

$$h_k = h_{2n-k}; d_{n-k} = 2h_k, k = 0,...,n-1; d_0 = h_n.$$

Details on the Parks-McClellan algorithm are outlined in T.Parks, J.McClellan, "Chebyshev Approximation for Nonrecursive Digital Filters with Linear Phase", IEEE Transactions on Circuit Theory, Vol. CT-19, No.2, March 1972.

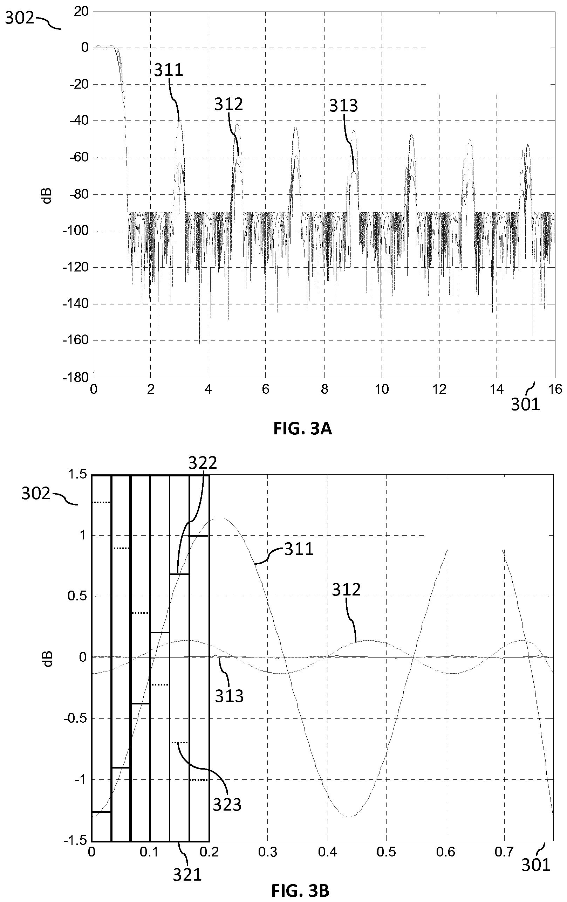

Typically, the quality of an anti-aliasing filter 102 (notably with respect to an amplitude ripple within the pass band) increases with an increasing number of filter coefficients (also referred to as filter taps). Fig. 3a shows the frequency response, i.e. the gain or attenuation 302 of the filter 102 as a function of frequency 301, for different anti-aliasing filters 102 having different numbers of filter taps. In particular, Fig. 3a shows the frequency response 311 of a filter 102 having 12 taps, the frequency response 312 of a filter having 16 taps and the frequency response 313 of a filter having 20 taps. Fig. 3b shows the amplitude ripple of the frequency responses 311, 312, 313 within the pass band. It can be seen that with increasing number of taps, the amplitude ripple of the frequency responses 311, 312, 313 (i.e. the deviation of the gain / attenuation 302 of the frequency responses 311, 312, 313 from a reference value of e.g. 1 or 0dB) may be decreased. On the other hand, the computational complexity increases with an increasing number of filter taps.

In various different applications, an audio signal 110, which is to be re-sampled, may be submitted to subband processing, which involves processing of the audio signal 110 in a subband domain (e.g. in a QMF, Quadrature Mirror Filter, domain). An example application is an audio decoder such as an AC-4 audio decoder which makes use of subband processing for expanding the bandwidth of an audio signal. Fig. 2 shows a block diagram of such an example audio decoder 200. The audio decoder 200 comprises a bitstream demultiplexing unit 201 which is configured to provide audio data 221 for a lowband audio signal 223 from a bitstream received at the decoder 200. Furthermore, the bitstream demultiplexing unit 201 is configured to provide metadata 222 which enables e.g. decoupling and/or upmixing of an audio signal (to generate a plurality of audio channels from a downmixed audio channel) and/or spectral band expansion (to expand the bandwidth of the lowband audio signal).

The audio data 221 may be provided to an audio decoding unit 202 which is configured to generate the lowband audio signal 223 from the audio data 221. The lowband audio signal 223 it typically a time domain audio signal (e.g. PCM encoded). The audio decoder 200 comprises a transform unit 203 which is configured to convert the time-domain lowband audio signal 223 into a subband domain signal comprising a set of lowband subband signals 224. The set of lowband subband signals 224 may be submitted to spectral band expansion using the metadata 222 within a spectral band expansion unit 204. In particular, a set of highband subband signals may be generated from the set of lowband subband signals 224 to provide an overall set of subband signals 210 (also referred to herein as a set of input subband signals 210).

The set of subband signals 210 or a modified version 213 thereof may be submitted to decoupling within a decoupling unit 206 to provide multiple sets of subband signals 225 from a single set of subband signals 210, 213 for multiple audio channels, respectively. Furthermore, the one or more sets of subband signals 225 may be submitted to optional subband procession within a subband processing unit 207. Furthermore, the one or more sets of subband signals may be converted from the subband domain into the time domain using an inverse transform unit 208, thereby providing one or more audio signals 110 for one or more channels.

In the following an example audio signal 110 provided by the decoder 200 is considered. This time domain audio signal 110 is obtained from a respective set of subband signals 210 using an inverse transform or a synthesis filterbank which is applied in the inverse transform unit 208. By way of example, the transform unit 203 and the inverse transform unit 208 comprise a QMF filter bank (e.g. with Q= 32 or 64 subbands).

There may be a need for resampling the audio signal 110 (also referred to as the input audio signal 110) using a rational resampler 100, thereby providing an output audio signal 113 at a different sampling rate. As outlined above, the resampler 100 typically comprises an anti-aliasing filter 102 having a certain frequency response 311, 312, 313 and exhibiting a varying gain / attenuation 302 within the pass band of the filter 102. In an ideal case, the anti-aliasing filter 102 exhibits a constant gain at a reference value (e.g. 0dB or 1) across the entire pass band (i.e. up to the pass band edge $f_p$). However, actual anti-aliasing filters 102 exhibit a deviation from this constant gain, as can be seen in Fig. 3b. This deviation may be referred to as ripple or amplitude ripple.

The decoder 200 may comprise a ripple pre-emphasis unit 205 which is configured to apply ripple pre-emphasis gains to the different subband signals of a set of input subband signals 210. In particular, a subband-dependent ripple pre-emphasis gain may be applied to some or all of the input subband signals 210, thereby providing a set of output subband signals 213. The set of output subband signals 213 (or a processed version thereof) may then be submitted to the inverse transform unit 208 to derive the audio signal 110 which is to be resampled within the resampler 100.

The ripple pre-emphasis gains may determined based on the frequency response 311 of the anti-aliasing filter 102 used within the resampler 100. Fig. 3b illustrates the frequency range of different subbands 321 of the subband domain along the frequency axis. It can be seen that different subbands 321 correspond to different spectral excerpts of the frequency response 311 of the anti-aliasing filter 102. Furthermore, it can be seen that the frequency response 311 of the anti-aliasing filter 102 exhibits a different gain / attenuation 302 within the different subbands 321. For some or all of the subbands 321 an effective gain 322 of the frequency response 311 of the anti-aliasing filter 102 (e.g. as the mean value of the gain / attenuation 302 within the different subbands 321) may be determined. The ripple pre-emphasis gain 323 for a particular subband 321 may correspond to the complementary value of the effective gain 322 of the frequency response 311 of the anti-aliasing filter 102 for the particular subband 321. In particular, the ripple pre-emphasis gain 323 $a_r$ in dB may be $a_r = -a_e$, with $a_e$ being the effective gain 322 in dB.

As such, the ripple which is caused by the anti-aliasing filter 102 of the resampler 100 may be compensated by applying a ripple pre-emphasis gain 323 to the subband signals 210 in the subband domain, thereby providing an input audio signal 110 to the resampler 100 which already takes into account the ripple which is caused by the anti-aliasing filter 102 of the resampler 100. As a result of this, the ripple of the anti-aliasing filter 102 does not affect the output audio signal 113. In other words, an artifact-free output audio signal 113 may be generated by performing ripple pre-emphasis within the subband domain.

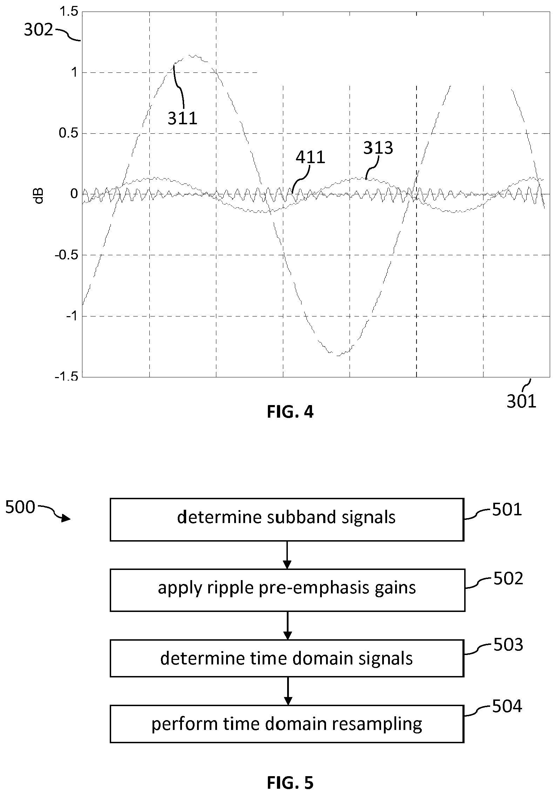

The use of ripple pre-emphasis within the subband domain enables the use of anti-aliasing filters 102 with a reduced number of filter taps. Fig. 4 shows the frequency response 311 of an anti-aliasing filter 102 having 12 taps and the frequency response 313 of an anti-aliasing filter 102 having 20 taps (without using ripple pre-emphasis within the subband domain). Furthermore, Fig. 4 shows the effective frequency response 411 of an anti-aliasing filter 102 having 12 taps in combination with ripple pre-emphasis. It can be seen that the frequency response 411 is almost constant within the pass band, even though an anti-aliasing filter 102 having only 12 taps has been used within the resampler 100. Hence, ripple pre-emphasis may be used to reduce the computational complexity of resampling, while maintaining a high perceptual quality for resampling, since applying pre-emphasis gains in the subband domain is computationally cheaper than adding filter taps to reduce the pass band ripple in the time domain filter.

In particular, resampling at a reduced computational complexity and good quality (in terms of low amplitude ripple and low aliasing energy) may be achieved within an audio decoder which employs QMF filter bank analysis-synthesis processing (as is the case e.g. for an AC4 codec). Amplitude ripple pre-emphasis may be applied within the QMF domain followed by time domain resampling subsequent to the QMF synthesis (within the inverse transform unit 208). Since the overall amplitude ripple is reduced by the QMF domain pre-emphasis (within the ripple pre-emphasis unit 205), the one or more time domain resampling filters 102 may be designed with reduced constraints regarding maximum amplitude ripple. Hence, for a given filter order the stop band attenuation may be increased (thereby achieving an increased quality at a constant complexity) or for a desired stop band attenuation the filter order may be reduced while maintaining low overall amplitude ripple.

The proposed scheme exploits the fact that amplitude modifications at high quality and low complexity may be achieved by the application of a subband-dependent gain within the QMF domain. Since typically the QMF domain is oversampled by a factor of 2 (due to the use of complex valued subband signals), the application of the ripple pre-emphasis gain 323 may require two multiplications per QMF subband. The QMF band ripple pre-emphasis gain 323 may be calculated as the inverse of the time domain filter magnitude response 302 within the pass band or it can be calculated in a least squares sense taking into account the filter bank net effect within a subband 321.

The anti-aliasing filter 102 may be designed such that the ripple amplitude of the filter 102 exhibits a period across frequency 301 which is substantially larger than the bandwidth of the subbands 321 of the subband transform (e.g. the QMF filterbank), e.g. 10, 15, 20 or more times larger. The bandwidth of the subbands 321 corresponds to the sample rate $fs_{in}$ of the input audio signal 110 divided by two times the number Q of subbands of the subband transform. As a result of such a filter design, ripple pre-emphasis may be applied in a reliable and precise manner.

By way of example, using the Parks-McClellan algorithm, the ripple period in the pass band may be increased by increasing the weight $W(f)$ of the design accuracy of the stop band higher relative to the design accuracy of the pass band design. An iterative search may be used to determine the relative weight $W(f)$ which provides the desired stop band attenuation and a reasonable pass band ripple which can be well compensated by QMF band ripple pre-emphasis gains.

Hence, complexity savings may be achieved by performing amplitude ripple pre-emphasis in the QMF domain, thereby reducing the requirements regarding amplitude ripple on the time domain anti-aliasing filter 102 of the resampler 100. In case of upsampling, the complexity is reduced further, due to the fact that ripple pre-emphasis is applied to the signal having the low sampling rate $fs_{in}$. In case of downsampling or in case of limited signal bandwidth only a fraction of the subbands 321 need to be processed using the ripple pre-emphasis gains 323. Furthermore, in case of parametric upmixing (within the decoupling unit 206) processing complexity can be reduced, because the ripple pre-emphasis gains 323 may be applied to the downmixed channels (wherein the anti-aliasing filter 102 is applied to the upmixed channels).

In an example use case, resampling by 16/15 is performed using a 64 band QMF filterbank. The input audio signal 110 is band limited to 50/64, with 64 corresponding to the Nyquist frequency $fs_{in}/2$. The conventional resampler 100 using a filter 102 with 16 filter taps requires 2 x 16 Multiply&Add-operations per output sample plus linear interpolation. The proposed scheme makes use of a filter 102 with 12 filter taps, which requires 2 x 12 Multiply&Add-operations per output sample plus linear interpolation. Furthermore, the ripple pre-emphasis requires 2 x 50/64 x 15/16 = 1.5 Multiply-operations per output sample. Both methods exhibit roughly the same stop band attenuation and overall peak-to-peak amplitude ripple. However, the proposed scheme enables a complexity reduction of roughly 6 Multiply&Add-operations per output sample.

Fig. 5 shows a flow chart of an example method 500 for resampling an audio signal 110. The method 500 comprising providing 501 a set of input subband signals 210. The set of input subband signals 210 may be provided by applying the analysis filters of an analysis filterbank to a time domain audio signal (e.g. to a lowband audio signal decoded using audio data 221 from a bitstream).

Furthermore, the method 500 comprises applying 502 a first ripple pre-emphasis gain 323 to a first input subband signal 210 of the set of input subband signals 210 to determine a corresponding first output subband signal 213 of a set of output subband signals 213. Typically, different ripple pre-emphasis gains 323 are applied to different input subband signals 210 of the set of input subband signals 210, thereby providing corresponding different output subband signals 210. The different ripple pre-emphasis gains 323 are frequency or subband dependent.

In addition, the method 500 comprises determining 503 a time domain input audio signal 110 from the set of output subband signals 213. This may be achieved by applying the synthesis filters of a synthesis filterbank to the set of output subband signals 213 or to a set of subband signals 225 derived from the set of output subband signals 213. The method 500 further comprises performing 504 time domain resampling of the input audio signal 110 to provide an output audio signal 113 using an anti-aliasing filter 102. The first ripple pre-emphasis gain 323 is typically dependent on and/or determined based on the frequency response 311 of the anti-aliasing filter 102. By making use of ripple pre-emphasis gains 323 which are applied in the subband domain, relatively short anti-aliasing filters 102 may be used, without increasing the effects of amplitude ripple on the output audio signal 113, thereby reducing the computational complexity for resampling.

The methods and systems described in the present document may be implemented as software, firmware and/or hardware. Certain components may e.g. be implemented as software running on a digital signal processor or microprocessor. Other components may e.g. be implemented as hardware and or as application specific integrated circuits. The signals encountered in the described methods and systems may be stored on media such as random access memory or optical storage media. They may be transferred via networks, such as radio networks, satellite networks, wireless networks or wireline networks, e.g. the internet. Typical devices making use of the methods and systems described in the present document are portable electronic devices or other consumer equipment which are used to store and/or render audio signals. The methods and system may also be used on computer systems, e.g. internet web servers, which store and provide audio signals, e.g. music signals, for download.

Various aspects of the present invention may be appreciated from the following enumerated example embodiments (EEEs):

EEE 1. A method (500) for resampling an audio signal (110), the method (500) comprising

- providing (501) a set of input subband signals (210);
- applying (502) a first ripple pre-emphasis gain (323) to a first input subband signal (210) of the set of input subband signals (210) to determine a corresponding first output subband signal (213) of a set of output subband signals (213);
- determining (503) a time domain input audio signal (110) from the set of output subband signals (213); and
- performing (504) time domain resampling of the input audio signal (110) to provide an output audio signal (113) using an anti-aliasing filter (102); wherein the first ripple pre-emphasis gain (323) is dependent on a frequency response (311) of the anti-aliasing filter (102).

EEE 2. The method (500) of EEE 1, wherein

- the first input subband signal (210) corresponds to a first subband of a plurality of subbands covering different frequency ranges; and
- the first ripple pre-emphasis gain (323) is dependent on the frequency response (311) of the anti-aliasing filter (102) within the first subband.

EEE 3. The method (500) of EEE 2, wherein the first ripple pre-emphasis gain (323) is dependent on an average amplitude or a median amplitude of the frequency response (311) of the anti-aliasing filter (102) within the first subband.

EEE 4. The method (500) of any of EEEs 2 to 3, wherein the first ripple pre-emphasis gain (323) is such that it at least partially compensates a deviation of an amplitude of the frequency response (311) of the anti-aliasing filter (102) within the first subband from a reference value.

EEE 5. The method (500) of any previous EEE, wherein

- the method comprises applying different ripple pre-emphasis gains (323) to the different input subband signals (210); and
- the different ripple pre-emphasis gains (323) are such that the ripple pre-emphasis gains (323) at least partially compensate an amplitude ripple of the frequency response (311) of the anti-aliasing filter (102).

EEE 6. The method (500) of any previous EEEs, wherein

- the input subband signals (210) of the set of input subband signals (210) correspond to different subbands of a plurality of subbands;
- the method (500) comprises applying different ripple pre-emphasis gains (323) to the different input subband signals (210);
- the ripple pre-emphasis gains (323) for the different subbands form a frequency-dependent gain curve;
- the frequency response (311) of the anti-aliasing filter (102) exhibits a frequency-dependent amplitude curve;
- the different ripple pre-emphasis gains (323) are such that
- the frequency-dependent gain curve approximates an inverse of the frequency-dependent amplitude curve; and/or
- a deviation of the frequency-dependent gain curve from the inverse of the frequency-dependent amplitude curve is equal to or smaller than a deviation threshold; and/or
- a product of the frequency-dependent gain curve and the frequency-dependent amplitude curve provides a frequency-dependent product curve having a variance which is lower than a variance of the frequency-dependent amplitude curve.

EEE 7. The method (500) of any previous EEEs, wherein the method (500) comprises determining the first ripple pre-emphasis gain (323) based on the frequency response (311) of the anti-aliasing filter (102).

EEE 8. The method (500) of any previous EEEs, wherein

- the time domain input audio signal (110) is determined using a synthesis filterbank comprising Q synthesis filters; and
- the first ripple pre-emphasis gain (323) is dependent on a power response of at least one of the Q synthesis filters.

EEE 9. The method (500) of EEE 8, wherein

- G is a row vector comprising L squared ripple pre-emphasis gains (323) for L input subband signals (210);
- P is a matrix with size LxK, which is indicative of a power response of L analysis-synthesis filter combinations at K pass band frequency points; and
- T is a row vector indicative of a power response of the anti-aliasing filter (102) at the K pass band frequency points; and

- G is determined such that GxP=1/T is approximated in a least squares error sense.

EEE 10. The method (500) of any previous EEEs, wherein the set of input subband signals (210) is provided from encoded audio data (221) of a bitstream.

EEE 11. The method (500) of any previous EEEs, wherein providing (501) the set of input subband signals (210) comprises applying an analysis filterbank comprising a plurality of analysis filters to a time domain audio signal.

EEE 12. The method (500) of EEE 11, wherein

- the analysis filters comprise quadrature mirror filters; and/or
- a number of analysis filters is 32, 64 or more.

EEE 13. The method (500) of any of EEEs 11 to 12, wherein

- the time domain audio signal is a lowband audio signal;
- the method (500) comprises determining a set of lowband subband signals (224) by applying the analysis filterbank to the lowband audio signal; and
- the method (500) comprises performing spectral band expansion using the set of lowband subband signals (224) and one or more spectral band expansion parameters to provide the set of input subband signals (210).

EEE 14. The method (500) of any previous EEEs, wherein determining (503) the time domain input audio signal (110) comprises applying a synthesis filterbank comprising a plurality of synthesis filters to a set of subband signals (215) derived from the set of output subband signals (213).

EEE 15. The method (500) of EEE 14, wherein

- the synthesis filters comprise quadrature mirror filters; and/or
- a number of analysis filters is 32, 64 or more.

EEE 16. The method (500) of any of EEEs 14 to 15, wherein the method (500) comprises

- upmixing the set of output subband signals (213) to a first and a second set of output subband signals (213) using one or more upmixing parameters; and
- deriving the set of subband signals (215) to which the synthesis filterbank is applied from the first set of output subband signals (213).

EEE 17. The method (500) of any previous EEEs, wherein

- the input audio signal (110) exhibits an input sampling rate;
- the output audio signal (113) exhibits an output sampling rate; and
- the ratio of the output sampling rate and the input sampling rate is a rational number N/M;
- the anti-aliasing filter (102) comprises a set of coefficients; and
- performing (504) time domain resampling comprises multiplying a coefficient from the set of coefficients with a sample of the input audio signal (110) to determine a sample of the output audio signal (113).

EEE 18. The method (500) of EEE 17, wherein

- the set of input subband signals (210) comprises Q input subband signals for Q different subbands ranging from 0Hz to half of the input sampling rate;
- the method (500) comprises determining a number L of subbands to which a ripple pre-emphasis gain (323) is to be applied, based on the output sampling rate and the input sampling rate; and
- the method (500) comprises applying a ripple pre-emphasis gain (323) to L out of the Q input subband signals (210).

EEE 19. The method (500) of EEE 18, wherein

- L is determined based on the ratio of the output sampling rate and the input sampling rate times Q, if the output sampling rate is smaller than the input sampling rate; and/or
- L is determined based on Q, if the output sampling rate is equal to or greater than the input sampling rate.

EEE 20. The method (500) of any of EEEs 17 to 19, wherein performing (504) time domain resampling comprises,

- selecting a first subset of coefficients from the set of coefficients; wherein the first subset comprises a first coefficient of the set and coefficients of the set following the first coefficient by multiples of N; and
- determining a first sample of the output audio signal (113) based on the first subset of coefficients and a first plurality of samples of the input audio signal (110).

EEE 21. The method of EEE 20, further comprising:

- selecting a second coefficient of the set based on the first coefficient and M;
- selecting a second subset of coefficients from the set of coefficients; wherein the second subset comprises the second coefficient and coefficients of the set following the second coefficient by multiples of N; and
- determining a second sample of the output audio signal (113) directly following the first sample, based on the second subset of coefficients and a second plurality of samples of the input audio signal (110).

EEE 22. The method of any previous EEEs, wherein

- the frequency response (311) exhibits an amplitude ripple in a pass band range from 0Hz to a Nyquist frequency of the input audio signal (110);
- the amplitude ripple exhibits R periods within the pass band range;
- the set of input subband signals (210) is determined using an analysis filterbank comprising Q analysis filters;
- R and Q are such that the ratio Q/R is equal to or greater than a pre-determined resolution value;
- the resolution value is 10, 20, 50 or more.

EEE 23. The method (500) of any previous EEE, wherein the method (500) comprises

- determining a bandwidth of the input audio signal (110); and
- determining a number of input subband signals (210) from the set of input subband signals (210) to which a ripple pre-emphasis gain (323) is to be applied based on the bandwidth of the input audio signal (110).

EEE 24. The method of any previous EEEs, wherein

- the set of input subband signals (210) is representative of a time domain audio signal at an input sampling rate;
- the input audio signal (110) exhibits the input sampling rate; and
- the output audio signal (113) exhibits an output sampling rate which differs from the input sampling rate.

EEE 25. The method of any previous EEEs, wherein the method comprises

- determining a weighted deviation of the frequency response of the anti-aliasing filter (102) from a target frequency response, using a pass band weight for a pass band of the frequency responses and a stop band weight for a stop band of the frequency responses; and

- determining the anti-aliasing filter (102) such that the weighted deviation is reduced.

EEE 26. The method of EEE 25, wherein the method comprises

- determining a stop band deviation of the frequency response of the anti-aliasing filter (102) from the target frequency response within the stop band; and
- determining the pass band weight and the stop band weight which are used for determining the anti-aliasing filter (102) such that the stop band deviation is equal to or smaller than a pre-determined deviation threshold.

EEE 27. A system for determining a resampled output audio signal (113), wherein the system (200) comprises,

- a transform unit (203) configured to provide a set of input subband signals (210);
- a pre-emphasis unit (205) configured to apply a first ripple pre-emphasis gain (323) to a first input subband signal (210) of the set of input subband signals (210) to determine a corresponding first output subband signal (213) of a set of output subband signals (213);
- an inverse transform unit (208) configured to determine a time domain input audio signal (110) from the set of output subband signal (213); and
- a resampling unit (100) configured to perform time domain resampling of the input audio signal (110) to provide an output audio signal (113) using an anti-aliasing filter (102); wherein the first ripple pre-emphasis gain (323) is dependent on a frequency response (311) of the anti-aliasing filter (102).

EEE 28. The system of EEE 27, wherein transform unit (203) and the inverse transform unit (208) form a perfect reconstruction filterbank or a near perfect reconstruction filterbank.

EEE 29. An audio decoder (200) configured to provide an output signal (113) from a bitstream comprising audio data (221) and metadata (222), wherein

- the audio decoder (200) comprises the system of any of EEEs 27 to 28; and
- the transform unit (203) is configured to provide the set of input subband signals (210) based on the audio data (221).

EEE 30. The audio decoder (200) of EEE 29, wherein the audio decoder (200) comprises a spectral band expansion unit (204) which is configured to provide at least some of the set of input subband signals (210) using the metadata (222).

EEE 31. A storage medium comprising a software program adapted for execution on a processor and for performing the method steps of any of the EEEs 1 to 26 when carried out on a computing device.

**Claims**

1. A method (500) for resampling an audio signal (110), the method (500) comprising

   - providing (501) a set of input subband signals (210) which is representative of a time domain audio signal;
   - applying (502) a first ripple pre-emphasis gain (323) to a first input subband signal (210) of the set of input subband signals (210) to determine a corresponding first output subband signal (213) of a set of output subband signals (213);
   - determining (503) a time domain input audio signal (110) from the set of output subband signals (213); and
   - performing (504) time domain resampling of the input audio signal (110) to provide an output audio signal (113) using an anti-aliasing filter (102); wherein the first ripple pre-emphasis gain (323) is dependent on a frequency response (311) of the anti-aliasing filter (102), such that an amplitude ripple of the frequency response (311) of the anti-aliasing filter (102) is at least partially compensated by the first ripple pre-emphasis gain (323).

2. The method (500) of claim 1, wherein

   - the first input subband signal (210) corresponds to a first subband of a plurality of subbands covering different frequency ranges; and
   - the first ripple pre-emphasis gain (323) is dependent on the frequency response (311) of the anti-aliasing filter (102) within the first subband.

3. The method (500) of claim 2, wherein the first ripple pre-emphasis gain (323) is dependent on an average amplitude or a median amplitude of the frequency response (311) of the anti-aliasing filter (102) within the first subband.

4. The method (500) of any of claims 2 to 3, wherein the first ripple pre-emphasis gain (323) is such that it at least partially compensates a deviation of an amplitude of the frequency response (311) of the anti-aliasing filter (102) within the first subband from a reference value.

5. The method (500) of any previous claim, wherein

    - the method comprises applying different ripple pre-emphasis gains (323) to the different input subband signals (210); and
    - the different ripple pre-emphasis gains (323) are such that the ripple pre-emphasis gains (323) at least partially compensate the amplitude ripple of the frequency response (311) of the anti-aliasing filter (102).

6. The method (500) of any previous claims, wherein

    - the input subband signals (210) of the set of input subband signals (210) correspond to different subbands of a plurality of subbands;
    - the method (500) comprises applying different ripple pre-emphasis gains (323) to the different input subband signals (210);
    - the ripple pre-emphasis gains (323) for the different subbands form a frequency-dependent gain curve;
    - the frequency response (311) of the anti-aliasing filter (102) exhibits a frequency-dependent amplitude curve;
    - the different ripple pre-emphasis gains (323) are such that

        - the frequency-dependent gain curve approximates an inverse of the frequency-dependent amplitude curve; and/or
        - a deviation of the frequency-dependent gain curve from the inverse of the frequency-dependent amplitude curve is equal to or smaller than a deviation threshold; and/or
        - a product of the frequency-dependent gain curve and the frequency-dependent amplitude curve provides a frequency-dependent product curve having a variance which is lower than a variance of the frequency-dependent amplitude curve.

7. The method (500) of any previous claims, wherein the method (500) comprises determining the first ripple pre-emphasis gain (323) based on the frequency response (311) of the anti-aliasing filter (102).

8. The method (500) of any previous claims, wherein

    - the time domain input audio signal (110) is determined using a synthesis filterbank comprising Q synthesis filters; and
    - the first ripple pre-emphasis gain (323) is dependent on a power response of at least one of the Q synthesis filters.

9. The method (500) of claim 8, wherein

    - G is a row vector comprising L squared ripple pre-emphasis gains (323) for L input subband signals (210);
    - P is a matrix with size LxK, which is indicative of a power response of L analysis-synthesis filter combinations at K pass band frequency points; and
    - T is a row vector indicative of a power response of the anti-aliasing filter (102) at the K pass band frequency points; and
    - G is determined such that GxP=1/T is approximated in a least squares error sense.

10. The method (500) of any previous claims, wherein the set of input subband signals (210) is provided from encoded audio data (221) of a bitstream.

11. The method (500) of any previous claims, wherein providing (501) the set of input subband signals (210) comprises applying an analysis filterbank comprising a plurality of analysis filters to a time domain audio signal,

    and optionally, wherein

        - the analysis filters comprise quadrature mirror filters; and/or
        - a number of analysis filters is 32, 64 or more.

12. The method (500) of claim 11, wherein

    - the time domain audio signal is a lowband audio signal;
    - the method (500) comprises determining a set of lowband subband signals (224) by applying the analysis filterbank to the lowband audio signal; and
    - the method (500) comprises performing spectral band expansion using the set of lowband subband signals (224) and one or more spectral band expansion parameters to provide the set of input subband signals (210).

13. The method (500) of any previous claims, wherein determining (503) the time domain input audio signal (110) comprises applying a synthesis filterbank comprising a plurality of synthesis filters to a set of subband signals (215) derived from the set of output subband signals (213).

14. The method (500) of claim 13, wherein the method (500) comprises

    - upmixing the set of output subband signals (213) to a first and a second set of output subband signals (213) using one or more upmixing parameters; and

- deriving the set of subband signals (215) to which the synthesis filterbank is applied from the first set of output subband signals (213).

15. A system for determining a resampled output audio signal (113), wherein the system (200) comprises,

- a transform unit (203) configured to provide a set of input subband signals (210) which is representative of a time domain audio signal;
- a pre-emphasis unit (205) configured to apply a first ripple pre-emphasis gain (323) to a first input subband signal (210) of the set of input subband signals (210) to determine a corresponding first output subband signal (213) of a set of output subband signals (213);
- an inverse transform unit (208) configured to determine a time domain input audio signal (110) from the set of output subband signal (213); and
- a resampling unit (100) configured to perform time domain resampling of the input audio signal (110) to provide an output audio signal (113) using an anti-aliasing filter (102); wherein the first ripple pre-emphasis gain (323) is dependent on a frequency response (311) of the anti-aliasing filter (102), such that an amplitude ripple of the frequency response (311) of the anti-aliasing filter (102) is at least partially compensated by the first ripple pre-emphasis gain (323).

110    111    112    113

100

101    102    103

**FIG. 1**

221    201    222    200

222

210    213    110    113

223    224    225

202    203    204    205    206    207    208    100

**FIG. 2**

FIG. 3A

FIG. 3B

**FIG. 4**

**FIG. 5**

Europäisches
Patentamt

European
Patent Office

Office européen
des brevets

# EUROPEAN SEARCH REPORT

Application Number

EP 17 16 1806

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 649 614 A1 (DOLBY INT AB [NL]) 16 October 2013 (2013-10-16) * paragraph [0006] * * paragraph [0047] *  ----- | 1-15 | INV. G10L21/00 H03H17/06 |
| A | EP 0 957 579 A1 (THOMSON BRANDT GMBH [DE]) 17 November 1999 (1999-11-17) * paragraph [0004] - paragraph [0014] *  ----- | 1-15 | |

TECHNICAL FIELDS
SEARCHED      (IPC)

G10L
H03H

The present search report has been drawn up for all claims

| Place of search | Date of completion of the search | Examiner |
|---|---|---|
| The Hague | 10 July 2017 | Schneider, Daniel |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 16 1806

This annex lists the patent family members relating to the patent documents cited in the above-mentioned European search report.
The members are as contained in the European Patent Office EDP file on
The European Patent Office is in no way liable for these particulars which are merely given for the purpose of information.

10-07-2017

| Patent document cited in search report | | Publication date | Patent family member(s) | | Publication date |
|---|---|---|---|---|---|
| EP 2649614 | A1 | 16-10-2013 | CN | 103262162 A | 21-08-2013 |
| | | | EP | 2649614 A1 | 16-10-2013 |
| | | | US | 2013253917 A1 | 26-09-2013 |
| | | | WO | 2012076689 A1 | 14-06-2012 |
| EP 0957579 | A1 | 17-11-1999 | CN | 1236222 A | 24-11-1999 |
| | | | DE | 69938441 T2 | 10-06-2009 |
| | | | EP | 0957579 A1 | 17-11-1999 |
| | | | JP | 2000068948 A | 03-03-2000 |
| | | | US | 6681209 B1 | 20-01-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 2649614 A1

**Non-patent literature cited in the description**

• **T.PARKS ; J.MCCLELLAN.** Chebyshev Approximation for Nonrecursive Digital Filters with Linear Phase. *IEEE Transactions on Circuit Theory,* March 1972, vol. CT-19 (2